Europäisches Patentamt

European Patent Office

Office européen des brevets

(11) Publication number: **0 389 989**
**A2**

## (12) EUROPEAN PATENT APPLICATION

(21) Application number: **90105589.7**

(22) Date of filing: **23.03.90**

(51) Int. Cl.5: **G11C 7/00, G11C 11/419**

(30) Priority: **25.03.89 JP 75279/89**

(43) Date of publication of application:
**03.10.90 Bulletin 90/40**

(84) Designated Contracting States:
**DE FR GB**

(71) Applicant: **SONY CORPORATION**
**7-35, Kitashinagawa 6-chome Shinagawa-ku**
**Tokyo(JP)**

(72) Inventor: **Suzuki, Hiroyuki**
**c/o Sony Corporation 7-35 Kitashinagawa**
**6-chome**
**Shinagawa-ku Tokyo(JP)**
Inventor: **Araki, Shigeo**
**c/o Sony Corporation 7-35 Kitashinagawa**
**6-chome**
**Shinagawa-ku Tokyo(JP)**
Inventor: **Yuki, Noboru**
**c/o Sony Corporation 7-35 Kitashinagawa**
**6-chome**
**Shinagawa-ku Tokyo(JP)**

(74) Representative: **TER MEER - MÜLLER -**
**STEINMEISTER & PARTNER**
**Mauerkircherstrasse 45**
**D-8000 München 80(DE)**

(54) Semiconductor memory device.

(57) A semiconductor memory device is comprises of a variable impedance load (1) in a bit line (11, 12). During readout, the variable impedance load (1) is controlled in response to word line selection to achieve higher impedance than that of previous timing. By the higher impedance mode, high speed level shift of bit lines (11, 12) is performed, and the access time is shortened.

FIG.2

## SEMICONDUCTOR MEMORY DEVICE

BACKGROUND OF THE INVENTION

(1) Field of the Invention

This invention relates to a semiconductor memory device, such as a static RAM, provided with variable resistor means for terminating bit lines.

(2) Description of the Prior Art

A static RAM in general is so organized that a large number of memory cells, each composed of a pair of inverter circuits, are arranged in a matrix configuration. To each memory cell are contacted with a pair of bit lines for data writing and readout. Data are written by applying a potential difference across the bit lines of each pair and are read out from the signal potential difference across the bit lines of each pair.

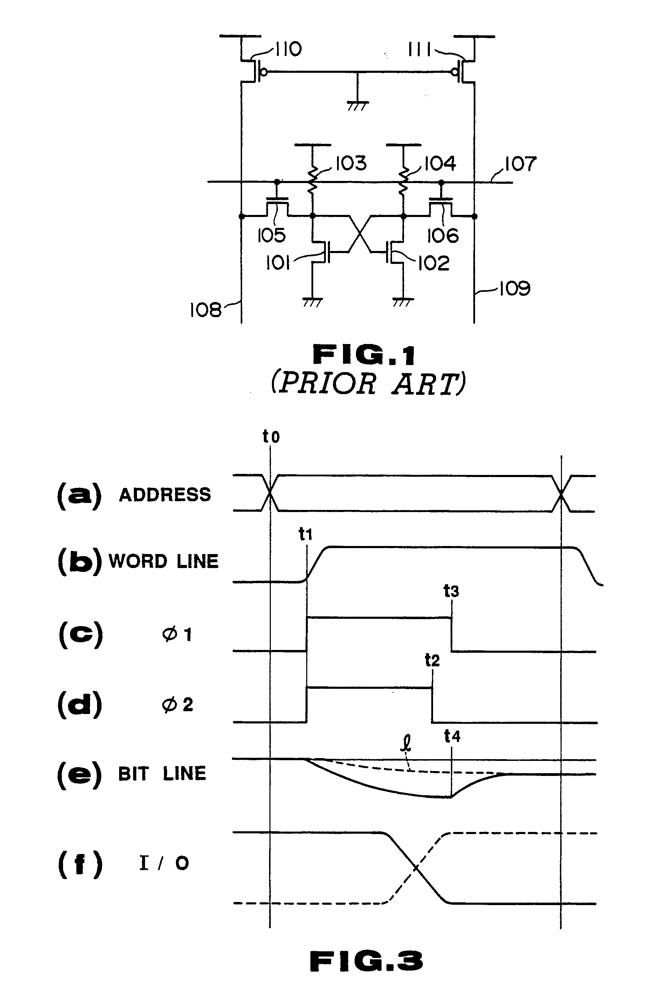

Fig. 1 shows an example of the static RAM having bit line loads. The memory cell shown therein includes a flip-flop composed of driving transistors 101, 102 and load resistors 103, 104, and access transistors 105, 106 each having a word line 107 as the common gate electrode. These access transistors function as a switch between the input and output nodes of the flip-flop and the bit line pair 108, 109. The bit line loads 110, 111 are provided for terminating the bit line pair 108, 109. By providing these bit line loads 110, 111, the electrical potential across the bit lines 108, 109 may be adjusted to effect desired writing and readout operations.

There is also known a static RAM provided with variable resistance means terminating the bit line pairs. For example, the Japanese Patent Publication No. 60-44747 (1985) discloses a technique of lowering the resistance of the bit line during readout as compared to that during reading for shortening the write recovery time.

However, in the static RAM of the example shown in Fig. 1 or in the technique described in the above Japanese Publication, the bit line load elements are at a low impedance during readout. Usually, during readout, the level of one of the bit lines 108 or 109 is pulled down from a high level by the corresponding one of the driving transistors 101 or 102 of the memory cell. However, if the bit line load element is at a low impedance, the bit line level can be pulled down difficultly and thus the potential difference increase across the bit lines is delayed so that the access time cannot be shortened in a desired manner.

SUMMARY OF THE INVENTION

It is an object of the present invention to provide a semiconductor memory device in which the impedance of variable resistance means during readout is controlled to realize the shortening of the access time.

For accomplishing the object, the semiconductor memory device of the present invention includes a word line, a bit line pair, a plurality of memory cells connected across said bit line pair and variable resistor means terminating said bit lines, wherein the variable resistor means is controlled in response to word line selection during readout so as to assume a resistance value higher than the previously prevailing value. Since the bit line level is determined during readout by the impedance ratio between the variable resistor means and the access transistor of the memory cell, it becomes possible, with the variable resistor means shifting to a high resistance value, to shift the bit line level more promptly.

The timing that the variable resistor means is controlled is at the same timing of word line selection, or at the timing within the allowable range of temporal deviation from word line selection. The variable resistor means may be constituted by variable resistance elements, such as pMOS or nMOS transistors, and control means for these variable resistance elements.

BRIEF DESCRIPTION OF THE DRAWINGS

Fig. 1 is a circuit diagram showing essential portions of an example of the conventional static RAM.

Fig. 2 is a circuit diagram showing an embodiment of the semiconductor memory device of the present invention.

Fig. 3 is a read-out timing chart thereof.

DETAILED DESCRIPTION OF THE INVENTION

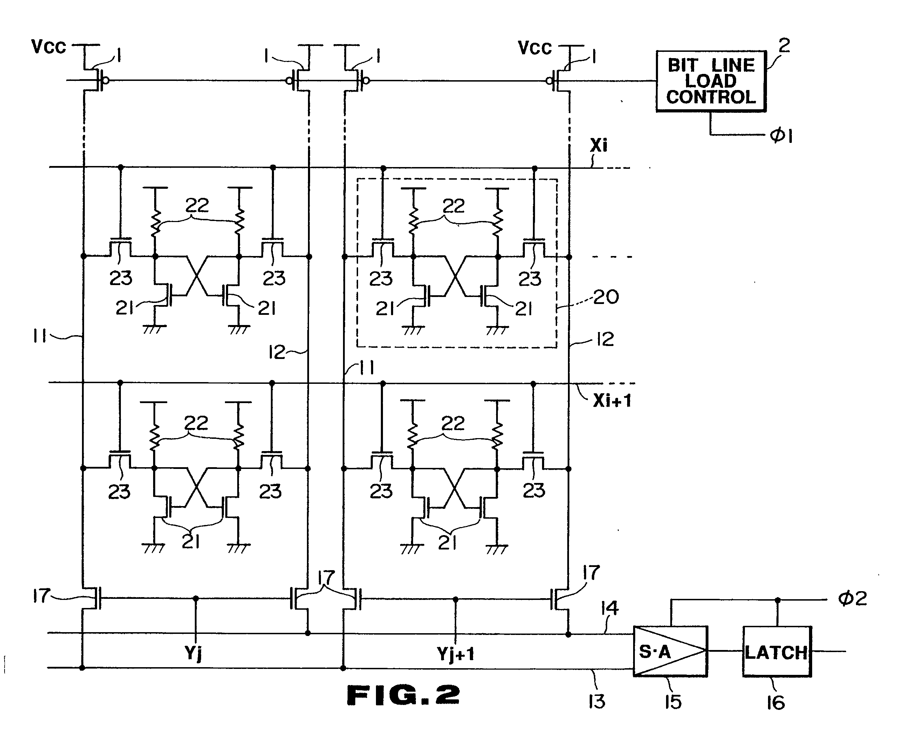

Fig. 2 shows an embodiment of a static RAM in which pMOS transistors 1 for terminating the bit lines are provided as variable load means.

Referring to Fig. 2, a plurality of memory cells 20 are arrayed in a matrix configuration. Each memory cell 20 is constructed as the usual memory cell and includes a pair of drive transistors 21, 21, a pair of resistance loads 22, 22 and a pair of access transistors 23, 23. The drive transistors 21, 21 have their sources supplied with a ground voltage GND and their gate and drain paths connected to each other. The resistance loads 22, 22 are connected between the source voltage Vcc and the drains of the drive transistors 21, 21 and the access transistors 23, 23 are provided between these drains and the bit lines 11, 12.

Word lines $X_i$, $X_{i+1}$, ... are arranged horizontally in the drawing for selecting a desired row of the memory cell 20 of the matrix configuration. These word lines $X_i$, $X_{i+1}$, ... function as gate electrodes of the access transistors 23, 23 at the memory cells 20 to control the turning on and off of the access transistors 23, 23. These word lines $X_i$, $X_{i+1}$, ... are activated by a row decoder, not shown, on the basis of address signals for performing the selecting operation.

The bit lines 11, 12 are arranged for intersecting the word lines $X_i$, $X_{i+1}$ substantially normally thereto, while each memory cell 20 is sandwitched between the bit line pair 11, 12 such that data exchange may be performed between the bit line pair 11, 12 and the memory cell 20. The bit line pairs 11, 12 are selected by column selecting transistors 17 having column selection lines $Y_j$, $Y_{j+1}$, ... as the gates. These column selection lines $Y_j$, $Y_{j+1}$, ... are supplied with column selection signals from a column decoder, not shown.

The bit line pairs 11, 12 are connected to a common data line pair 13, 14 via column selection transistors 17. The common data line pair 13, 14 is connected to a sense amplifier 15, to the output side of which a latch circuit 16 is connected. The same amplifier 15 is activated by a signal $\phi2$ to sense the electrical potential difference across the common data lines 13, 14 during readout to generate an output signal. This output signal is latched by the latch circuit 16 at the falling timing of the signal $\phi2$ to establish the read out data.

On each of the bit lines 11, 12, a pMOS transistor 1 is provided for terminating the bit lines 11, 12. Each pMOS transistor 1 has its source supplied with a source voltage Vcc and its source proving to be the bit line 11 or 12. An impedance control signal from a bit line load control circuit 2 is supplied in common to the gates of the pMOS transistors 1. With the rising of the signal $\phi1$, the bit line load control circuit 2 pulls the impedance control signal to a high level to raise the impedance of the pMOS transistor 1. On the other hand, with the falling of the signal $\phi1$, the bit line load control circuit 2 pulls the impedance control signal to a low level while lowering the impedance of the pMOS transistor 1. the signal $\phi1$ is supplied from, for example, an address transition detection circuit (ATD), not shown, and a pulse is supplied during readout at the rising timing at the word lines $X_i$, ...

at each cycle.

The read-out operation of the above described static RAM of the present embodiment is hereinafter explained by referring to Fig. 3.

Supposing that an address signal (a) is changed at time $t_0$, each decoder is activated, with the level (b) of the selected word line $X_i$ ... charging from the low level to the high level at time $t_1$. Simultaneously, at the same timing as the selecting operation of the word line $X_i$, ... , the signal $\phi1$ shown at (c) and the signal $\phi2$ shown at (d) are raised from the low level to the high level. With the rising of the signal $\phi1$, the bit line load control circuit 2, supplied with the signal $\phi1$, is activated to pull the impedance control signal to the high level. This raises the impedance of the pMOS transistor 1 as the variable resistor means. Also, with the signal $\phi2$, operation of the sense amplifier 15 is initiated.

As the level of the word line $X_i$, ... is raised increasingly, one of the drive transistors 21, 21 of the selected memory cell 20, that is the drive transistor 21 at the logical "0", its turned on. With the drive transistor 21 thus turned on, the level of one of the bit lines 11 or 12 it pulled down via access transistor 23, as shown at (e) in Fig. 3. At this time, the pMOS transistor 1 is at the high resistance level by the impedance control signal from the bit line load control circuit 2. Thus the level of one of the bit lines 11, 12 shifts to high level more promptly to provide an electrical potential difference between the bit lines 11, 12 more promptly.

The broken line in Fig. 3 illustrates, for comparison sake, the changes in level produced when the pMOS transistor 1 is caused to remain at the low impedance state. When the pMOS transistor 1 is at the low impedance, as in the prior-art example, the bit lines 11, 12 are perpetually drawn towards the source voltage Vcc so that the level changes are retarded, whereas, with the present embodiment, the level changes occur more promptly, as indicated by the solid line at (e) in Fig. 3.

Sensing is terminated at time $t_2$ and the signal $\phi2$ falls. With the falling of the signal $\phi2$, data are latched by the latch circuit 16. As a result, output data are established, as indicated at level (E) of the I/0 line in Fig. 3.

After the data establishment, the signal $\phi1$ shifts at time $t_3$ from the high level to the low level. This causes the impedance control signal from the bit line load control circuit 2 supplied with signal $\phi1$ to shift to the low level, the pMOS transistor 1 shifting to the low resistance level. With the pMOS transistor 1 thus shifting to the low resistance level, the level (e) on the bit lines 11 or 12, thus far lowered, is pulled up since time $t_4$. Then, equalizing and precharging of the required ones of the bit lines and common data lines are performed in a manner not shown.

With the above described static RAM, pMOS transistor 1 shifts to the high impedance state, at the time of readout, simultaneously with selection of the word lines $X_i$, ... and, after the data establishment by sense amplifier 15 or latch circuit 16, pMOS transistor 1 shifts to the low impedance state. In this manner, when the driving transistor 21 of the selected memory cell 20 is turned on, pMOS transistor 1 is at the high impedance state, as a result of which the bit line level shifting occurs more promptly.

Although the variable resistor is constituted by pMOS transistor 1, it may also be constituted by nMOS transistor. Although pMOS transistor 1 shifts to high resistance simultaneously with word line selection, the timing of shifting to high impedance may be set to be before or after word line selection in keeping with the timing of coming into operation of the drive transistor 21 of the memory cell 20. The impedance control signal controlling the variable resistor means may be such a signal as will change gradually instead of changing between two values, that is low and high values.

## Claims

1. A semiconductor memory device comprising:
a plurality of memory cells (20) arranged in a matrix configuration for storage of data therein,
a plurality of word lines ($X_i$, $X_{i+1}$,...) for selecting associated ones of rows of said memory cells,
bit lines (11, 12) arranged in pairs, with each pair of said bit lines associated with a column of said memory cells and used for writing or reading data into or from said memory cells,
and
variable resistor means (1) arranged for terminating said bit lines (11, 12) and controlled in response to word line selection during data readout so as to assume a resistance value higher than the previously prevailing value.

2. A static random access memory or SRAM comprising:
a plurality of memory cells (20) arranged in a matrix configuration, each memory cell consisting of a flip-flop (21, 21, 22) circuit and access transistors (23, 23) and being arranged for storage of data therein,
a plurality of word lines ($X_i$, $X_{i+1}$,...) controlling said access transistors (23, 23) and selecting associated ones of rows of said memory cells,
bit lines (11, 12) arranged for associated ones of columns of said memory cells and used for writing or reading data into or from said memory cells, and

variable resistor means (1) arranged for terminating said bit lines (11, 12) and controlled in response to word line selection during data readout so as to assume a resistance value higher than the previously prevailing value.

3. The SRAM according to claim 2 wherein said variable resistor means is constituted by variable resistor element ar ranged between said bit lines and source voltage line and a control circuit for controlling the impedance of said variable resistor elements.

4. The SRAM according to claim 3 wherein said variable resistor element is an MOS transistor.

5. The SRAM according to claim 2 wherein the timing of shifting to a high resistance value is obtained by a signal from an address transition detection circuit.

6. The SRAM according to claim 2 further comprising a sense amplifier (15) for amplifying the bit line potential,
and
a latch circuit (16) for latching data from said sense amplifier,
wherein, after establishment fo readout data by said latch circuit, said variable resistor means (1) is reset from the high resistance state to the low resistance state.

**FIG.1**
*(PRIOR ART)*

**(a)** ADDRESS

**(b)** WORD LINE

**(c)** $\phi 1$

**(d)** $\phi 2$

**(e)** BIT LINE

**(f)** I / O

**FIG.3**

FIG.2